# EUROPEAN PATENT SPECIFICATION

(11) **EP 2 599 132 B1**
(45) Date of publication and mention of the grant of the patent: **18.03.2015**
(21) Application number: 11749220.7
(22) Date of filing: 25.07.2011
(51) Int. Cl.: H01L 33/00, H01L 33/08, H01L 21/30, H01L 33/32

(54) **LIGHT EMITTING DIODES**
LICHTEMITTIERENDE DIODEN
DIODES ÉLECTROLUMINESCENTES

(30) Priority: 26.07.2010 GB 201012483
(43) Date of publication of application: 05.06.2013
(73) Proprietor: Seren Photonics Limited, Bridgend CF32 9BS (GB)
(72) Inventor: WANG, Tao, Bents Green Sheffield S11 7RJ (GB)
(74) Representative: Wilson, Alan Stuart
(86) International application number: PCT/GB2011/051407
(87) International publication number: WO 2012/013965

(56) References cited:
- CA-C- 2 024 134
- DE-A1- 19 652 471
- US-A1- 2009 026 476
- US-A1- 2010 120 237
- CHIU C H ET AL: "Fabrication of InGaN/GaN nanorod light-emitting diodes with self-assembled Ni metal islands", NANOTECHNOLOGY, vol. 18, no. 44, 7 November 2007 (2007-11-07), page 445201, XP020129422, IOP, BRISTOL, GB ISSN: 0957-4484
- CHAO C ET AL: "Freestanding high quality GaN substrate by associated GaN nanorods self-separated hydride vapor-phase epitaxy", APPLIED PHYSICS LETTERS, vol. 95, no. 5, 051905, 4 August 2009 (2009-08-04), pages 1-3, XP012122531, AIP, AMERICAN INSTITUTE OF PHYSICS, MELVILLE, NY, US ISSN: 0003-6951, DOI: 10.1063/1.3195684
- I. ADESIDA ET AL: "Dry and Wet Etching for Group III - Nitrides", MRS PROCEEDINGS, vol. 537, 1 January 1998 (1998-01-01), page 11PP, XP055010355, ISSN: 0272-9172, DOI: 10.1557/PROC-537-G1.4

## Description

### Field of the Invention

The present invention relates to light emitting diodes (LEDs), in particular to methods of increasing the quantum efficiency of LEDs formed from nano-rod arrays.

### Background to the Invention

As described in our patent application PCT/GB2010/050992, LEDs consisting of nano-rod arrays can exhibit enhanced performance. Group III-nitride nano-rod arrays are well suited to this use. Nano-rod array LED can be produced in many ways, such as electron-beam lithography with subsequent dry-etching, nano-imprinting with subsequent dry-etching, or any self-organized mask with subsequent dry-etching. Generally, dry-etching, which comprises bombarding the wafer with ions, for example from silicon chloride, causes heavy damage in III-nitrides, which leads to the presence of surface states in a surface region of the semiconductor material and severe degradation in optical performance.

Also exposure of InGaN/GaN nano-rods to air or any ambient containing oxygen can cause oxidation. This oxidation also leads to the presence of the surface state, so that the enhancement in optical efficiency due to the nano-rod configuration is reduced. The oxidation process depends sensitively on the ambient temperature. Specifically, the higher the temperature, the more severe the oxidation. In the worst case, the oxidation can quench the optical emission completely. There can be a number of annealing processes involved in fabricating InGaN/GaN nanorod based emitters, and in some certain steps, the annealing may have to be performed under oxygen ambient. In such cases the issue will become more severe, leading to very weak or negative enhancement in optical efficiency.

Chiu C H et al "Fabrication of InGaN/GaN nanorod light-emitting diodes with self-assembled Ni metal islands", Nanotechnology, vol. 18, no.44, 7 November 2007, page 445201, XP020129422, ISSN; 0957-4484 describes a method of producing LEDs in which nanocolumns are etched using a nickel mask which is subsequently removed using acid.

### Summary of the Invention

The invention provides a method of producing a light emitting device comprising: providing a wafer structure including a light emitting layer of III-nitride semiconductor material; dry etching the wafer at least part way through the light emitting layer so as to leave exposed surfaces of the emitting layer; and treating the exposed surfaces of the emitting layer with nitric acid at a temperature of at least 100°C, wherein the nitric acid is at a concentration of at least 50% by volume.

The dry etching may be arranged to leave a plurality of columns, with the exposed surfaces being the surfaces of the columns. Typically the columns are on the nano-scale.

The surfaces may be treated for at least 1 minute, or more preferably at least 3 minutes.

The light emitting layer may include at least one of InGaN, GaN, AlGaN and GaN. More specifically the light emitting layer may include InₓGa₁₋ₓN or AlyGa_{1-y}N, (where 0≤x≤1 and 0≤y≤1) For example the emitting layer may comprise adjacent layers of InGaN (or InₓGa₁₋ₓN) and GaN, or adjacent layers of AlGaN (or Al_{y}Ga_{1-y}N) and GaN. The light emitting layer may comprise at least one quantum well layer, and preferably comprises a plurality of quantum well layers. The quantum well layer or layers may comprise InGaN (or InₓGa₁₋ₓN) or AlGaN(or Al_{y}Ga_{1-y}N). The quantum well layer or layers may be between layers of a different semiconductor material, which may be a group III nitride, and may be GaN.

The acid treatment may be arranged to modify the exposed surfaces so as enhance the photoluminosity of the device.

The surface modification may be arranged to reduce or eliminate the presence of a surface state at the surface of the pillars, in particular the surface of the active layer. Surface states, as described above, generally enhance non-radiative recombination processes in the III-nitride material, and therefore lead to degradation in optical performance of the device. For example the surface state of the material may have a Fermi level which is different from that in the main bulk of the pillar.

The surface modification may therefore include changing the Fermi level of the material at its surface region.

The surface modification may comprise changing the Fermi level in the surface region towards that in the main body of the pillars, or the main body of the active layer of the pillars.

The surface state or states may be intrinsic, or extrinsic, or may be a combination of intrinsic and extrinsic surface states. The surface treatment may be arranged to reduce the presence of either an intrinsic or an extrinsic surface state, or both.

Surface states originating from clean and well ordered surfaces are usually called intrinsic. These states include states originating from reconstructed surfaces, where the two-dimensional translational symmetry gives rise to the band structure in the k space of the surface. Extrinsic surface states are usually defined as states not originating from a clean and well ordered surface, such as the surface defects and oxidation effects described above. Surfaces that are fit into the category extrinsic are:
1. Surfaces with defects, where the translational symmetry of the surface is broken.
2. Surfaces with adsorbates
3. Interfaces between two material such as a semiconductor-oxide or semiconductor-metal interfaces
4. Interfaces between solid and liquid phases.

States falling within any one or more of these categories may be reduced by the treatment of the present invention.

Generally extrinsic surface states cannot easily be characterized in terms of their chemical, physical or structural properties.

Preferred embodiments of the present invention will now be described by way of example only with reference to the accompanying drawings.

### Brief Description of the Drawings

**Figure 1** is a section through a light emitting device according to an embodiment of the invention;
**Figure 2** shows an example of a nano-pillar array fabricated during production of the device of Figure 1;
**Figure 3** shows the nano-pillar array of Figure 2 being immersed in acid during fabrication of the device of Figure 1 by a method according to an embodiment of the invention;
**Figure 4** is a graph showing photoluminescence intensity for a number of devices according to the invention;
**Figure 5** shows schematically a nano-pillar array being treated with hydrogen plasma during fabrication of a device by a method according to an example not forming part of the invention;
**Figure** 6 shows a nano-pillar array being treated with hydrogen plasma during fabrication in an ICP chamber; and
**Figure 7** is a graph showing photoluminescence intensity for a number of devices including one made by the method of Figure 5.

### Description of the Preferred Embodiments

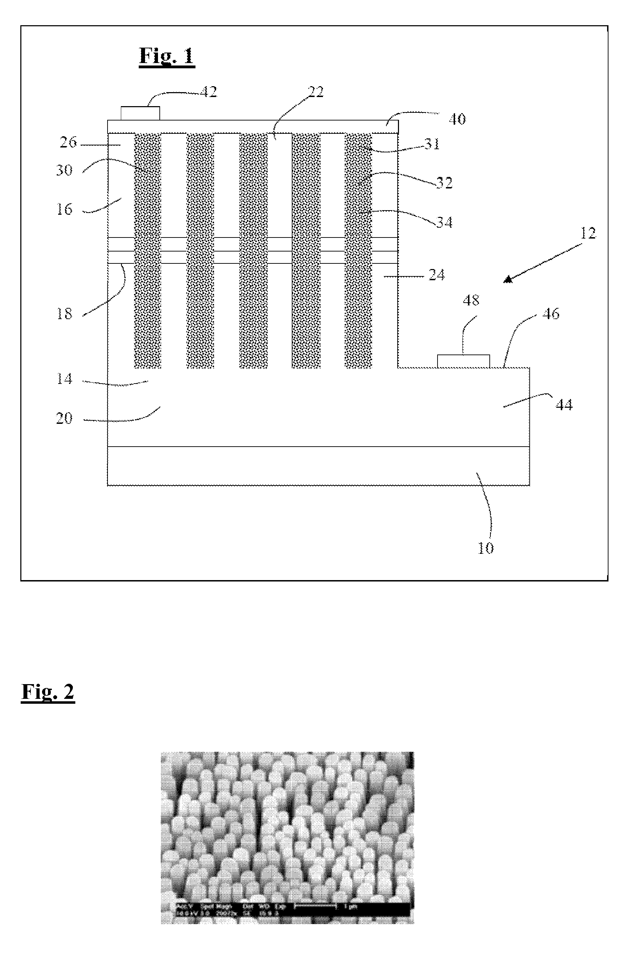

Referring to Figure 1, a light emitting device according to an embodiment of the invention comprises a substrate 10, which in this case comprises a layer of sapphire, with a semi-conductor diode system 12 formed on it. The diode system 12 comprises a lower layer 14 and an upper layer 16, with emitting layers 18 between them. The lower layer 14 is an n-type layer, in this case formed of n-doped gallium nitride (n-GaN), and the upper layer 16 is a p-type layer, in this case formed of p-doped gallium nitride (p-GaN). The emitting layers in this embodiment are formed of InₓGa₁₋ₓN which forms InₓGa₁₋ₓN quantum well (QW) layers and In_{y}Ga_{1-y}N which forms barrier layers (where x > y, and x or y from 0 to 1). These therefore provide multiple quantum wells within the emitting layers 18. In another embodiment, there is a single In_{z}Ga_{1-z}N layer (z from 0 to 1) which forms a single emitting layer.

When an electric current passes through the semiconductor diode system 12, injected electrons and holes recombine in the emitting layers 18 (sometimes referred to as active layers), releasing energy in the form of photons and thereby emitting light. The p-type layer 16 and n-type layer 14 each have a larger band gap than the emitting layers.

Structurally the semi-conductor diode system 12 comprises a nano-pillar structure, which comprises a continuous base layer 20 with a plurality of nano-pillars 22 projecting from it. The n-type layer 14 makes up the base layer and the lower part 24 of the nano-pillars, the p-type layer 16 makes up the upper part 26 of the nano-pillars, and the emitting layers 18 make up an intermediate part of the nano-pillars 22. Therefore the p-type layer 16, the emitting layers 18, and part of the n-type layer are all discontinuous, and the base layer 20 closes the bottom end of the gaps 30. The nano-pillars 22 are of the order of hundreds of nanometers in diameter, i.e. between 100 and 1000nm.

In this embodiment the gaps 30 in the discontinuous layers, between the nano-pillars 22, are filled with a mixture 31 of wavelength-conversion material 32 (which could be an insulating transparent material or semiinsulating transparent material) 32 and metal particles 34. Thus the wavelength-conversion material acts as a support material to support the metal particles 34 in the gaps 30. This mixture 31 fills the gaps 30 and forms a layer from the base layer 20 up to the top of the nano-pillars 22. In this embodiment it will be appreciated that the gaps 30 are in fact joined together to form one interconnected space that surrounds all of the nano-pillars 22. If the nano-pillars 22 are formed so that the maximum distance between adjacent nano-pillars 22 is, say, 200 nm then the maximum distance from any one of the metal particles 34 to a surface of one of the nano-pillars 22 is 100 nm. In which case, any of the metal particles 34 that is coplanar with the emitting layers 18 is in a position which permits surface plasmon coupling. Moreover, the metal particles 34 are suspended in the wavelength conversion material 32 and distributed randomly throughout it. Therefore, in this case, most of the particles 34 will be positioned less than 100 nm (and for some particles, effectively zero nm) from a surface of one of the nano-pillars 22.

The wavelength-conversion material 32 in this case is a polymer material, but could be a phosphor; in addition, cadmium sulphide may be used but many suitable types of wavelength-conversion material 32 will be apparent to those skilled in the art.

The metal particles 34 are silver. The size of the metal particles 34 is from a few nm to about 1 µm, depending in part on the size of the pillars, and the particle concentration in the wavelength-conversion material 32 is from 0.0001%w/w up to 10%w/w. In other embodiments the metal particles 34 can be gold, nickel or aluminium, for example. The choice of metal is based on the wavelength, or frequency of light from the emitting layers 18; for example silver is preferred for blue LEDs but aluminium is preferred for ultraviolet LEDs.

In another embodiment the same nano-pillar structure is used, but neither the wavelength conversion material 32 nor the metal particles are present. In a still further embodiment, the wavelength conversion material is present, but the metal particles are not.

A transparent p-contact layer 40 extends over the tops of the nano-pillars 22, being in electrical contact with them, and also extends over the top of the gaps 30 closing their top ends. A p-contact pad 42 is formed on the p-contact layer 40. A portion 44 of the base region 14 extends beyond the nano-pillars 22 and has a flat upper surface 46 on which an n-contact 48 is formed.

The device of Figure 1 is produced by first forming the nano-pillar structure 20, 22. This is done by forming the n-type layer 14 on the sapphire substrate 10, forming the emitting layers 18, such as the quantum well layers, on the n-type layer 14, forming the p-type layer 16 over the emitting layers 18, and then etching down through the layers 16, 18, 14 to form the gaps 30, leaving the nano-pillars 22. To control the etching, a mask is formed on the p-type layer 16, in a known manner, by first forming a layer of SiO₂ thin film over the p-type layer 16, followed by forming a nickel layer with thickness ranging from 5 to 50 nm. The sample is subsequently annealed under flowing N₂ at temperature 600-900 °C for 1 to 10 min. Under such conditions, the thin nickel layer can be developed into self-assembled nickel islands with a scale of 100s of nm on the SiO₂ surface. The self-assembled nickel islands then serve as a mask to etch the underlying oxide into SiO₂ nano-rods on the p-GaN surface by reactive ion etching (RIE). Finally, the SiO₂ nano-rods serves as a second mask, and then using inductively coupled plasma (ICP) etching the p-GaN layer is dry-etched down through the p-type layer 16, the emitting layers 18, and part way through the n-type layer 14, until the structure of Figure 1 is achieved. The etching is monitored, for example using a 650 nm laser, until the desired depth is reached. This leaves the nano-pillar structure 20, 22.

A standard photolithography can be carried out in order to have the region 44 of the base layer with a flat upper surface 46 on which the n-type contact can be formed.

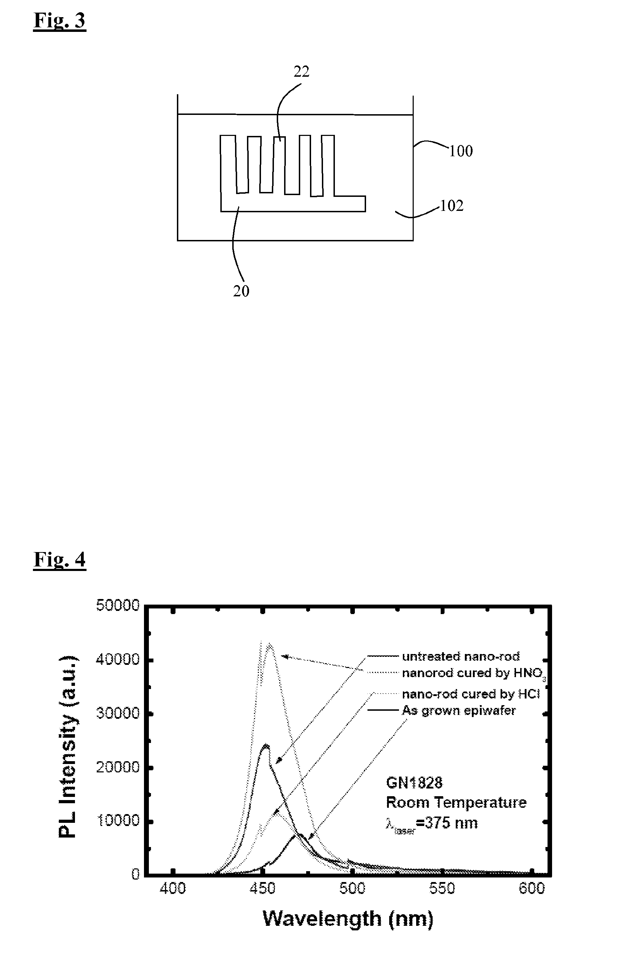

Once the nano-pillar structure 20, 22 has been formed, the exposed surfaces of the nano-pillars, including the side walls of the n-type lower parts 24, the side walls of the emitting layers 18, and the side walls of the p-type upper parts 26, are cured or treated in order to enhance their optical characteristics. In this embodiment the nano-pillars are treated by bringing them into contact with nitric acid, in this example at 70% concentration by volume in water at 260°C for 5 minutes. Referring to Figure 3, this is done by immersing the entire wafer structure 20, 22 in a bath 100 of the nitric acid 102. This cures the surface of the emitting layers 18 which enhances their optical performance in terms of optical efficiency, as will be described below. It also cures the surfaces of the lower and upper parts 24, 26 of the nano-pillars.

In this embodiment, once the surfaces of the emitting layers in the nano-pillars 22 have been cured, the mixture 31 of a wavelength-conversion material 32, and metal particles 34 is inserted into the gaps 30 by spin coating.

The transparent p-contact layer 40 is then formed over the top of the pillars 22, closing the top end of the gaps 30 and making electrical contact with the tops of the nano-pillars 22. Finally the p-contact pad 42 is formed on the p-contact layer 40, and the n-contact 48 is formed on the flat surface 46.

The nano-pillars can be formed in a number of different ways, which still benefit from the curing step. For example the mask defining the position of the nano-pillars can be obtained by electron-beam lithography, with subsequent dry-etching of the nano-pillars, or the mask can be formed by nano-imprinting with subsequent dry-etching of the nano-pillars, or indeed any self-organized mask can be used, with subsequent dry-etching of the nano-pillars. The dry etching can be, for example, Inductively Coupled Plasma (ICP) etching, or Reactive Ion Etching (RIE). The dry-etching can go down through the p-type layer 16, the emitting layers 18, and part way through the n-type layer until the structure as shown in Figure 1 is achieved. Alternatively the dry etching can go down only part way through the emitting layers 18, so that it does not reach the n-type layer 14.

To test the effect of curing the emitting layers 18, the photoluminescence intensity, as a function of wavelength, was measured for the wafer prior to formation of the nano-pillars, after the formation of the nano-pillars but without curing, after curing of the nano-pillars with hydrochloric acid, and after curing of the nano-pillars with nitric acid. In each case no wavelength conversion material or metal particles were applied to the wafer. The results are shown in Figure 4. As can be seen, the formation of nano-pillars increases the photoluminescence intensity. Curing the nano-pillars with nitric acid further increases the photo-luminescence considerably, whereas curing the nano-pillars with hydrochloric acid actually decreases the photo-luminescence of the device.

As described above, the physical mechanisms that affect the optical properties of the active layer are believed to be due to generation of surface effects on the surface of the nano-pillars during the process of dry-etching or any other process step, such annealing under an ambient containing oxygen. This leads to a change in the Fermi level of the semiconductor material at the surface, and in a surface layer or region, of the active layers of the nano-pillars. This change in Fermi level enhances the occurrence of non-radiative recombination processes in the active layer, thus reducing the optical efficiency in the active layer when an electrical current is passed through it. This change in Fermi level can be induced as a result of defects in the semiconductor lattice structure, which can be caused by the dry etching that forms the nano-pillars, or it can be as a result of oxidation of the surface of the nano-pillars, and in particular the active layer, which can also occur during the dry etching process. The treatment with nitric acid can chemically reduce/remove the defect or the oxidation or both so that the surface states can be reduced or eliminated. Therefore, the treatment leads to the restored enhancement in optical efficiency which should be exhibited as a result of fabrication into nano-rod array structure.

The treatment is arranged to reduce/eliminate the presence of both intrinsic and extrinsic surface states in the surfaces of the active layers of the nano-pillars.

Therefore, since the surface states can be produced by oxidation as well as by the dry etching, it will be appreciated that in some embodiments of the invention, the nano-pillars can be formed using methods other than dry etching, and subsequently undergo oxidation before the surface treatment step is perfomed.

In another embodiment the LED is a green LED emitting at a wavelength of about 525nm. The nano-particles can be of silver, platinum, nickel or gold and, as will be appreciated, the size of the particles can be chosen so as to determine the wavelength of the emitted light.

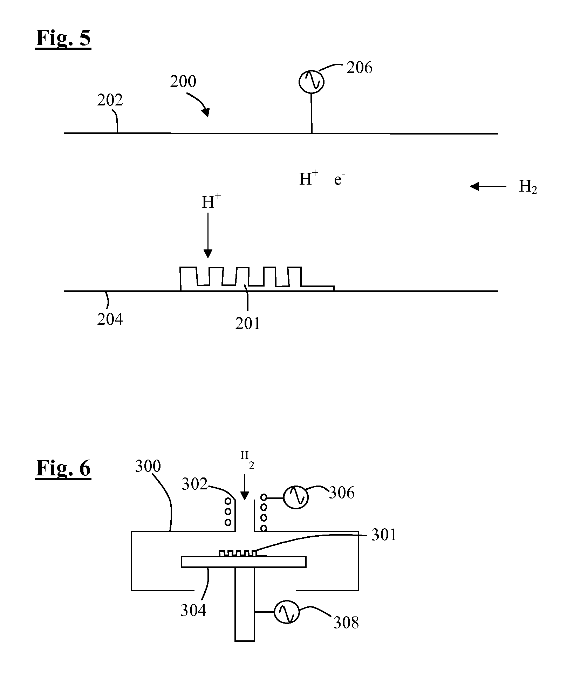

Referring to Figure 5, in a further example not forming part of the invention, the process is the same as for the first embodiment, except that the treatment with nitric acid is replaced by a treatment with hydrogen (H₂) plasma, which is performed in an ICP (inductively coupled plasma) chamber 200. The ICP chamber 200 is conventional. The sample is placed in the chamber which has two electrodes 202, 204 to one of which a radio frequency (RF) signal is applied. Hydrogen is introduced into the chamber and forms a plasma under the influence of the RF field, and then the positive ions of the plasma (protons) bombard the sample 201. In this example the hydrogen is at a pressure of 35 mTorr at a flow rate of 20 standard cubic centimetre per minute (sccm) and the sample is treated at room temperature for 2 minutes with an RF power of 100W.

It will be appreciated that the hydrogen flow rate and pressure, and the RF power and exposure time can be optimised for any particular nano-pillar structure.

Referring to Figure 6, in a further example not forming part the process is again the same as the first embodiment, but again with hydrogen gas treatment. In this case the ICP chamber is of a known configuration and comprises an annular chamber 300 with a tubular gas inlet 302 in the centre of its circular top wall. A circular sample table 304 is rotatably mounted in the chamber 300, coaxially with it. A coil 305 is located around the inlet 302 and connected to an RF supply 306. The RF supply is arranged to apply and RF signal to the coil 305 which converts hydrogen in the inlet 302 to a plasma. A separate RF supply is connected to the table 304 and arranged to apply an RF signal to that, the power of which determines the energy with which the plasma impacts the sample on the sample table.

In this example the ICP chamber is an ICP380-100 produced by Oxford Instruments. It has a chamber diameter of 380mm and a table diameter of 240mm. The flow rate is preferably 20 sccm, but could be from 10 to 30 sccm. The RF supply 306 to the coil 305 can be set at 1000W, and the RF supply to the table can be set at 100W. The sample was again treated at room temperature for 2 minutes. The pressure of the hydrogen plasma the chamber can be 35 mTorr. In another embodiment the ICP chamber is an Oxford Instruments ICP380-133 which has a 330 mm diameter table and a chamber diameter of 380 mm. In another embodiment the ICP chamber is an Oxford Instruments ICP65 which has a 240 mm diameter table with uniform plasma over a central 50mm diameter area.

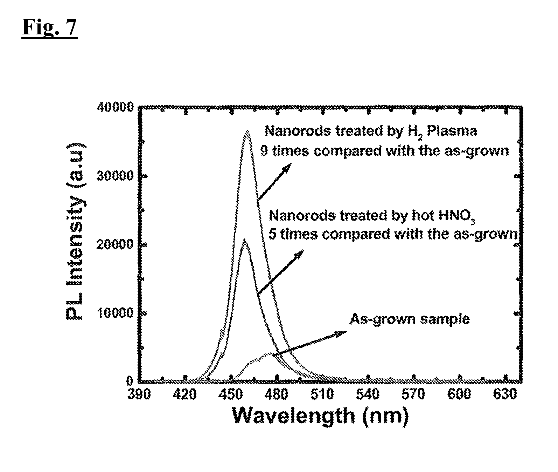

Referring to Figure 7, the photoluminescence intensity of an LED device formed as described above and treated with hydrogen plasma was compared with a device formed as described above and treated with nitric acid, and also with a device in which the wafer was grown, but no nano-pillars were formed. As can be seen the nano-pillars treated with nitric acid have about five times the photoluminescence intensity of the as-grown device, and the nano-pillars treated with hydrogen plasma have a photoluminescence intensity about nine times that of the as-grown device.

It is believed that the hydrogen plasma treatment reduces/eliminates the presence of surface states, or alters the Fermi level of the surface region of the semiconductor device, in a similar way to the nitric acid treatment.

This involves a reduction/elimination in the presence of both intrinsic and extrinsic surface states.

## Claims

1. A method of producing a light emitting device comprising:
providing a wafer structure including a light emitting layer of III-nitride semiconductor material;
dry etching the wafer at least part way through the light emitting layer so as to leave exposed surfaces of the emitting layer; and
treating the exposed surfaces of the emitting layer with nitric acid at a temperature of at least 100°C, wherein the nitric acid is at a concentration of at least 50% by volume

2. A method according to claim 1 wherein the light emitting layer includes at least one of InGaN, GaN, AlGaN and GaN.

3. A method according to claim 2 wherein the emitting layer comprises adjacent layers of InGaN and GaN, or adjacent layers of AlGaN and GaN.

4. A method according to any foregoing claim wherein the surfaces are treated for at least 1 minute.

5. A method according to claim 4 wherein the surfaces are treated for at least 3 minutes.

## Patentansprüche

1. Ein Verfahren zur Herstellung einer lichtemittierenden Vorrichtung, bestehend aus: der Bereitstellung einer Wafer-Struktur, die eine lichtemittierende Schicht aus einem III-Nitrid-Halbleiter-Material einschließt;
Trockenätzen des Wafer zumindest teilweise durch die lichtemittierende Schicht um exponierte Flächen der emittierenden Schicht zu erhalten; und
Behandlung der exponierten Flächen der emittierenden Schicht mit Salpetersäure bei einer Temperatur von mindestens 100°C, wobei die Salpetersäure eine Konzentration von mindestens 50 Volumenprozent aufweist.

2. Ein Verfahren gemäß Anspruch 1, wobei die lichtemittierende Schicht mindestens eines aus InGaN, GaN, AlGaN oder GaN einschließt.

3. Ein Verfahren gemäß Anspruch 2, wobei die lichtemittierende Schicht benachbarte Schichten aus InGaN und GaN oder benachbarte Schichten aus AlGaN und GaN umfasst.

4. Ein Verfahren gemäß eines der vorhergehenden Ansprüche, wobei die Flächen mindestens 1 Minute behandelt werden.

5. Ein Verfahren Anspruch 4, wobei die Flächen mindestens 3 Minuten behandelt werden.

## Revendications

1. Un procédé de production d'un dispositif d'émission de lumière comprenant : la fourniture d'une structure de plaquette comprenant une couche d'émission de lumière d'un matériau semiconducteur au nitrure III,
la gravure à sec de la plaquette au moins partiellement au travers de la couche d'émission de lumière de façon à laisser exposées des surfaces de la couche d'émission, et
le traitement des surfaces exposées de la couche d'émission avec de l'acide nitrique à une température d'au moins 100°C, où l'acide nitrique est à une concentration d'au moins 50% en volume.

2. Un procédé selon la Revendication 1 où la couche d'émission de lumière contient au moins un élément parmi InGaN, GaN, AlGaN et GaN.

3. Un procédé selon la Revendication 2 où la couche d'émission comprend des couches adjacentes d'InGaN et de GaN ou des couches adjacentes d'AlGaN et de GaN.

4. Un procédé selon l'une quelconque des Revendications précédentes où les surfaces sont traitées pendant au moins 1 minute.

5. Un procédé selon la Revendication 4 où les surfaces sont traitées pendant au moins 3 minutes.
